# EUROPEAN PATENT APPLICATION

(11) **EP 4 404 277 A1**
(43) Date of publication of application: **24.07.2024**
(21) Application number: 23793984.8
(22) Date of filing: 08.06.2023
(51) Int. Cl.: H01L 29/872, H01L 21/329, H01L 29/06, H01L 29/47

(54) **SCHOTTKY BARRIER DIODE**

(30) Priority: 06.12.2022 JP 2022194924
(71) Applicant: Shindengen Electric Manufacturing Co., Ltd., Tokyo 100-0004 (JP)
(72) Inventor: HASHIMOTO, Masaki, Asaka City, Saitama 351-8503 (JP); SUEMOTO, Ryuji, Asaka City, Saitama 351-8503 (JP); SENDA, Satoru, Asaka City, Saitama 351-8503 (JP)
(74) Representative: Isern Patentes y Marcas S.L.
(86) International application number: PCT/JP2023/022170
(87) International publication number: WO 2024/122085

(57) **Abstract**

Provided is a Schottky barrier diode capable of controlling a Schottky barrier height (ΦBn) to various values. The Schottky barrier diode including: a silicon layer; and a silicide layer that is disposed on the silicon layer and contains Pt and Ni. A peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm is 1 at% to 60 at%.

## Description

### CROSS REFERENCE TO RELATED APPLICATION

This patent application claims the benefit and priority of Japanese Patent Application No. 2022-194924 filed on December 6, 2022, the disclosure of which is incorporated by reference herein in its entirety as part of the present application.

### TECHNICAL FIELD

The present invention relates to a Schottky barrier diode.

### BACKGROUND ART

The Schottky barrier diode is a diode having rectifying properties by utilizing a Schottky barrier formed at a contact portion between a metal and a semiconductor. Since the Schottky barrier diode has an extremely small amount of accumulated charges in carriers, the Schottky barrier diode has characteristics in that turn-on time and turn-off time are extremely short. Accordingly, the Schottky barrier diode is used in many applications such as detection and mixer, high-speed switching, and rectification on a secondary side of power supplies. A technique related to this is disclosed in Japanese Patent No. 3983689.

The performance of a diode is expressed by characteristic values of a forward voltage VF that is a voltage applied in a direction from an anode to a cathode, and a reverse current IR that is a minute current flowing when applying a reverse voltage in a direction from the cathode to the anode.

In the Schottky barrier diode, when a Schottky barrier height (ΦBn) can be made to be high, IR decreases but VF increases. In contrast, when ΦBn can be made to be low, IR increases but VF decreases. In this manner, VF and IR have a trade-off relationship. In addition, VF of the Schottky barrier diode is smaller in comparison to a typical PN diode.

Here, the Schottky barrier diode may be required to have various values of Schottky barrier heights (ΦBn) so as to obtain desired characteristics.

Therefore, a Schottky barrier diode capable of controlling ΦBn to various values is required.

### SUMMARY OF INVENTION

### PROBLEM TO BE SOLVED BY THE INVENTION

An object of various aspects of the invention is to provide a Schottky barrier diode capable of controlling a Schottky barrier height (ΦBn) to various values, and a manufacturing method thereof.

### MEANS FOR SOLVING PROBLEM

Hereinafter, various aspects of the invention will be described.
[1] A Schottky barrier diode, including:
   a silicon layer; and
   a silicide layer that is disposed on the silicon layer and contains Pt and Ni,
   in which a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm is 1 at% to 60 at%.
      According to the Schottky barrier diode described in [1] according to the aspect of the invention, the silicide layer containing Pt and Ni is disposed on the silicon layer, and proportions and a concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 60 at%. According to this, a Schottky barrier height (ΦBn) can be controlled to various values, and as a result, desired characteristics in the Schottky barrier diode can be obtained.
[2] The Schottky barrier diode according to [1],
   in which the peak value of the concentration of Pt is 50 at% or less.
   According to the Schottky barrier diode described in [2] according to the aspect of the invention, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 50 at%. According to this, the Schottky barrier height (ΦBn) can be controlled to various values, and as a result, desired characteristics in the Schottky barrier diode can be obtained.
[3] The Schottky barrier diode according to [1],
   in which the peak value of the concentration of Pt is 40 at% or less.
   According to the Schottky barrier diode described in [3] according to the aspect of the invention, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 40 at%. According to this, the Schottky barrier height (ΦBn) can be controlled to various values, and as a result, desired characteristics in the Schottky barrier diode can be obtained.
[4] The Schottky barrier diode according to [1],
   in which the peak value of the concentration of Pt is 30 at% or less.
   According to the Schottky barrier diode described in [4] according to the aspect of the invention, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 30 at%. According to this, the Schottky barrier height (ΦBn) can be controlled to various values, and as a result, desired characteristics in the Schottky barrier diode can be obtained.
[5] The Schottky barrier diode according to [1],
   in which the peak value of the concentration of Pt is 20 at% or less.
   According to the Schottky barrier diode described in [5] according to the aspect of the invention, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 20 at%. According to this, the Schottky barrier height (ΦBn) can be controlled to various values, and as a result, desired characteristics in the Schottky barrier diode can be obtained.
[6] The Schottky barrier diode according to [1],
   in which the peak value of the concentration of Pt is 10 at% or less (or 7 at% or less, 5.5 at% or less, or 4 at% or less).
   According to the Schottky barrier diode described in [6] according to the aspect of the invention, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 10 at%. According to this, the Schottky barrier height (ΦBn) can be controlled to various values, and as a result, desired characteristics in the Schottky barrier diode can be obtained.
[7] The Schottky barrier diode according to any one of [1] to [6], further including:
   a PtNi alloy layer or a mixed layer of Pt and Ni disposed on the silicide layer.
   According to the Schottky barrier diode described in [7] according to the aspect of the invention, the silicide layer containing Pt and Ni is disposed on the silicon layer, and Pt is contained in the interface between the silicide layer and the silicon layer. In addition, the Schottky barrier height (ΦBn) can be controlled to various values by adjusting the proportions and the concentration distribution of Pt and Ni contained in the silicide layer, and as a result, desired characteristics in the Schottky barrier diode can be obtained.
[8] The Schottky barrier diode according to any one of [1] to [7], further including:
   a guard ring that is located at an end of the silicide layer and is disposed inside the silicon layer.
   According to the Schottky barrier diode described in [8] according to the aspect of the invention, the guard ring that is located at an end of the silicide layer and is disposed inside the silicon layer is provided, and thus a withstand voltage of the Schottky barrier diode can be raised.
[9] The Schottky barrier diode according to any one of [1] to [8], further including:
   a groove that is formed in the silicon layer and is located below the silicide layer;
   an insulator layer disposed on an inner wall of the groove; and
   a conductor layer that is disposed inside the groove and on the insulator layer,
   in which the silicon layer is disposed adjacent to the groove.
   According to the Schottky barrier diode described in [9] according to the aspect of the invention, the groove located below the silicide layer is formed in the silicon layer, the insulator layer is disposed on the inner wall of the groove, the conductor layer is disposed inside the groove and on the insulator layer, and the silicon layer is disposed adjacent to the groove. Even in the Schottky barrier diode having the trench structure, the proportions and the concentration distribution of Pt and Ni contained in the silicide layer are adjusted so that the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm becomes 1 at% to 60 at%. According to this, a Schottky barrier height (ΦBn) can be controlled to various values, and as a result, desired characteristics can be obtained.
[10] The Schottky barrier diode according to any one of [1] to [8],
   in which a first laminated structure layer or a second laminated structure layer is disposed on the silicide layer,
   the first laminated structure layer is a layer in which an Al layer and a Ni layer are sequentially laminated, and
   the second laminated structure layer is a layer in which the Ni layer and the Al layer are sequentially laminated.
[11] The Schottky barrier diode according to any one of [1] to [8],
   in which a Ti layer or a Mo layer is disposed on the silicide layer.
[12] The Schottky barrier diode according to any one of [1] to [8],
   in which a Ti layer is disposed on the silicide layer, and a Mo layer is disposed on the Ti layer.
[13] The Schottky barrier diode according to any one of [1] to [8], further including:
   a laminated film disposed on the silicide layer,
   in which the laminated film is a film in which at least two films among an Al film, a Ni film, and a Mo film are laminated.
[14] The Schottky barrier diode according to any one of [1] to [13],
   in which the silicon layer is an epitaxial layer, and
   a silicon substrate is disposed below the epitaxial layer.
[15] The Schottky barrier diode according to any one of [1] to [14],
   in which the peak value of the concentration of Pt occurs at the interface or on the interface side in the silicide layer.
[16] A method of manufacturing a Schottky barrier diode, including:
   a process (a) of forming a Pt layer on a silicon layer;
   a process (b) of performing a heat treatment on the Pt layer and the silicon layer at a temperature of 150°C to 300°C to form a Pt silicide layer on the silicon layer;
   a process (c) of forming a Ni layer on the Pt silicide layer; and
   a process (d) of performing a heat treatment on the silicon layer, the Pt silicide layer, and the Ni layer at a temperature of 300°C to 600°C to form a silicide layer containing Pt and Ni on the silicon layer, and to form a PtNi alloy layer or a mixed layer of Pt and Ni on the silicide layer,
   in which the thicknesses of the Ni layer and the Pt layer, and a ratio of the thicknesses are adjusted, and
   a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm is 1 at% to 60 at%.
   According to the method of manufacturing a Schottky barrier diode described in [16] according to another aspect of the invention, the process (a) of forming the Pt layer on the silicon layer, and the process (b) of performing a heat treatment on the Pt layer and the silicon layer at a temperature of 150°C to 300°C to form the Pt silicide layer on the silicon layer are provided. The Pt layer that is not silicided may remain on the Pt silicide layer. Next, when the Ni layer is formed on the Pt silicide layer, and the heat treatment is performed on the silicon layer, the Pt silicide layer, and the Ni layer at a temperature of 300°C to 600°C, a silicide layer containing Pt and Ni is formed on the silicon layer and a PtNi alloy layer or a mixed layer of Pt and Ni is formed on the silicide layer. Since the Pt silicide layer is formed on the silicon layer by the process (b), the peak value of the concentration of Pt in the silicide layer with a thickness of 50 nm on the silicide layer side from the interface between the silicide layer and the silicon layer, or the peak value of the concentration of Pt in the silicide layer in a case where the thickness of the silicide layer is less than 50 nm can be set to 1 at% to 60 at%. Particularly, the peak value of the concentration of Pt can be caused to occur at the interface between the silicide layer and the silicon layer, or on the interface side in the silicide layer. According to this, the Schottky barrier height (ΦBn) can be controlled to various values, and as a result, desired characteristics in the Schottky barrier diode can be obtained.
[17] A method of manufacturing a Schottky barrier diode, including: a process (a) of forming a Pt layer on a silicon layer while heating the silicon layer at a temperature of 150°C to 300°C to form a Pt silicide layer on the silicon layer while forming the Pt layer;
   a process (b) of forming a Ni layer on the Pt silicide layer; and
   a process (d) of performing a heat treatment on the silicon layer, the Pt silicide layer, and the Ni layer at a temperature of 300°C to 600°C to form a desired silicide structure on the silicon layer,
   in which the silicide structure in the process (d) is a silicide layer containing Pt and Ni, and a PtNi alloy layer or a mixed layer of Pt and Ni is formed on the silicide layer containing Pt and Ni, and
   a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm after the process (d) is 1 at% to 60 at%.
[18] The method of manufacturing a Schottky barrier diode according to [17],
   in which the process (b) is a process of forming a Ni layer on the Pt silicide layer while heating the silicon layer at a temperature of 150°C to 300°C.
[19] The method of manufacturing a Schottky barrier diode according to [17], in which the process (b) is a process of forming a Ni layer on the Pt silicide layer while heating the silicon layer at a temperature of 100°C to 250°C.
[20] The method of manufacturing a Schottky barrier diode according to [17],
   in which the process (b) is a process of sequentially and continuously forming a Ni layer, a Ti layer, a Mo layer, and an Al layer on the Pt silicide layer while heating the silicon layer at a temperature of 100°C to 250°C.
[21] The method of manufacturing a Schottky barrier diode according to any one of [16] to [19], further including:
   a process of removing the PtNi alloy layer or the mixed layer of Pt and Ni after the process (d).

### EFFECT OF THE INVENTION

According to the various aspects of the invention, it is possible to provide a Schottky barrier diode capable of controlling a Schottky barrier height (ΦBn) to various values.

### BRIEF DESCRIPTION OF DRAWINGS

Fig. 1 is a cross-sectional view illustrating a Schottky barrier diode according to an aspect of the invention;
Fig. 2 is a cross-sectional view illustrating a first modification example of the Schottky barrier diode illustrated in Fig. 1;
Figs. 3A and 3B are a cross-sectional view describing a method of preparing a Schottky junction portion illustrated in Fig. 1;
Fig. 4 is a cross-sectional view describing a method of preparing the Schottky junction portion illustrated in Fig. 1;
Fig. 5 is a cross-sectional view describing a modification example of a method of preparing the Schottky junction portion illustrated in Fig. 1;
Fig. 6 is a cross-sectional view illustrating a trench Schottky barrier diode according to another aspect of the invention;
Fig. 7 is a view illustrating a profile of proportions of respective elements Si, Pt, and Ni in a silicide layer 12a with a thickness of 50 nm on the silicide layer 12a side from an interface between a silicon layer 11 and the silicide layer 12a in a prepared sample of Example 1 of the Schottky barrier diode illustrated in Fig. 1; and
Fig. 8 is a view illustrating a profile of proportions of the respective elements Si, Pt, and Ni in the silicide layer 12a with a thickness of 50 nm on the silicide layer 12a side from the interface between the silicon layer 11 and the silicide layer 12a in a prepared sample of Example 2 of the Schottky barrier diode illustrated in Fig. 1.

### DESCRIPTION OF EMBODIMENTS

Hereinafter, embodiments of the invention will be described in detail with reference to the accompanying drawings. However, the invention is not limited to the following description, and it should be easily understood by those skilled in the art that aspects and details can be modified in various manners without departing from the gist and range of the invention. Accordingly, the invention is not intended to be interpreted with a limitation to contents of the following embodiments of the invention.

### (First Embodiment)

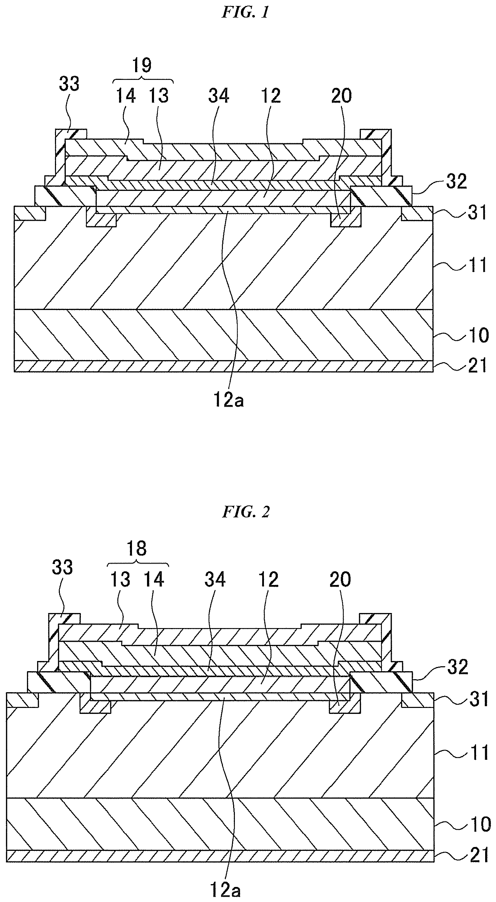

Fig. 1 is a cross-sectional view illustrating a Schottky barrier diode according to an aspect of the invention.

The Schottky barrier diode in Fig. 1 includes a silicon layer 11, and a silicide layer 12a containing Pt and Ni is disposed on the silicon layer 11. A junction between the silicon layer 11 and the silicide layer 12a forms a Schottky junction. A peak value of a concentration of Pt in the silicide layer 12a with a thickness of 50 nm on the silicide layer 12a side from an interface between the silicide layer 12a and the silicon layer 11, or a peak value of the concentration of Pt in the silicide layer 12a in a case where the thickness of the silicide layer 12a is less than 50 nm may be 1 at% to 60 at%, preferably 50 at% or less, more preferably 40 at% or less, still more preferably 30 at% or less, yet more preferably 20 at% or less, and even more preferably 10 at% or less (or 7 at% or less, 5.5 at% or less, or 4 at% or less).

In addition, the peak value of the concentration of Pt may occur at the interface or on an interface side in the silicide layer 12a.

As described above, the silicide layer 12a containing Pt and Ni is disposed on the silicon layer 11, and proportions and a concentration distribution of Pt and Ni contained in the silicide layer 12a are adjusted so that the peak value or the like of the concentration of Pt in the silicide layer 12a with a thickness of 50 nm on the silicide layer 12a side from the interface between the silicide layer 12a and the silicon layer 11 becomes 1 at% to 60 at% or the like. According to this, the Schottky barrier height (ΦBn) occurring at the interface between a metal and a semiconductor can be controlled to various values, and as a result, desired characteristics in the Schottky barrier diode can be obtained.

As illustrated in Fig. 1, a silicon substrate 10 is disposed below the silicon layer 11, and the silicon layer 11 is, for example, an epitaxial layer formed on the silicon substrate 10. In addition, a rear electrode 21 is formed on a rear surface of the silicon substrate 10, and a metal such as Ni, Ti, Au, Ag, and Al may be used as the rear electrode 21.

In addition, a PtNi alloy layer 12 is disposed on the silicide layer 12a. Note that, in this embodiment, the PtNi alloy layer 12 is disposed on the silicide layer 12a, but a mixed layer of Pt and Ni may be disposed on the silicide layer 12a.

As described above, the silicide layer 12a containing Pt and Ni may be disposed on the silicon layer 11, and Pt may be contained at an interface between the silicide layer 12a and the silicon layer 11. In addition, the Schottky barrier height (ΦBn) can be controlled to various values by adjusting proportions and a concentration distribution of Pt and Ni contained in the silicide layer 12a, and as a result, desired characteristics in the Schottky barrier diode can be obtained.

As illustrated in Fig. 1, a guard ring 20 located below an end of the PtNi alloy layer 12 is disposed inside the silicon layer 11. A withstand voltage of the Schottky barrier diode can be raised due to the guard ring 20.

In addition, a first laminated structure layer 19 is formed on the PtNi alloy layer 12, and the first laminated structure layer 19 is a layer in which an Al layer 13 and a Ni layer 14 are sequentially laminated. Note that, in this embodiment, the first laminated structure layer 19 is formed on the PtNi alloy layer 12, but as illustrated in Fig. 2, a second laminated structure layer 18 may be formed on the PtNi alloy layer 12, and the second laminated structure layer 18 is a layer in which the Ni layer 14 and the Al layer 13 are sequentially laminated. Note that, Fig. 2 is a cross-sectional view illustrating a first modification example of the Schottky barrier diode illustrated in Fig. 1, and is similar to the Schottky barrier diode illustrated in Fig. 1 except that the first laminated structure layer 19 is modified to the second laminated structure layer 18.

In addition, in the silicon layer 11, a channel stopper layer 31 located on an outer side of the guard ring 20 is formed to be separated from the guard ring 20. The channel stopper layer 31 is formed in a ring shape.

In addition, a passivation layer 32 is formed on the silicon layer 11 and on an outer side of the PtNi alloy layer 12, and the passivation layer 32 is in contact with the PtNi alloy layer 12 and is located between the guard ring 20 and the channel stopper layer 31. As the passivation layer 32, for example, an SiO₂ layer, a phosphorous silicate glass (PSG) layer, or an Si₃N₄ layer can be used.

In addition, as illustrated in Fig. 1, a Ti layer 34 is formed between both the PtNi alloy layer 12 and the passivation layer 32, and the first laminated structure layer 19. Note that, in this embodiment, the Ti layer 34 is formed between both the PtNi alloy layer 12 and the passivation layer 32, and the first laminated structure layer 19, but a modification can be made so that the Ti layer 34 is not formed and the first laminated structure layer 19 may be formed on both the PtNi alloy layer 12 and the passivation layer 32.

A polyimide film 33 as a protective film is formed on side walls of the channel stopper layer 31, the Ti layer 34, and the first laminated structure layer 19, and on the first laminated structure layer 19, but the polyimide film 33 is not formed at the center of an upper surface of the first laminated structure layer 19.

Note that, in this embodiment, the PtNi alloy layer 12 is formed between the silicide layer 12a containing Pt and Ni and the Ti layer 34, but a modification may be made so that the PtNi alloy layer 12 is removed and the Ti layer 34 is formed on the silicide layer 12a containing Pt and Ni, or preparation may be performed so that the PtNi alloy layer 12 may not be formed by forming the silicide layer 12a containing Pt and Ni.

According to this embodiment, the silicide layer 12a containing Pt and Ni is disposed on the silicon layer 11, and Pt is contained at an interface between the silicide layer 12a and the silicon layer 11. In addition, proportions and a concentration distribution of Pt and Ni contained in the silicide layer 12a are adjusted so that a peak value of the concentration of Pt in the silicide layer 12a with a thickness of 50 nm on the silicide layer 12a side from the interface between the silicide layer 12a and the silicon layer 11, or a peak value of the concentration of Pt in the silicide layer 12a in a case where the thickness of the silicide layer 12a is less than 50 nm becomes 1 at% to 60 at%. According to this, by adjusting proportions and a concentration distribution of Pt and Ni contained in the silicide layer 12a, a Schottky barrier height (ΦBn) can be controlled to various values, and as a result, desired characteristics in the Schottky barrier diode can be obtained.

Note that, in this embodiment, the Ti layer 34 is formed on the PtNi alloy layer 12, but a modification may be made so that a Mo layer instead of the Ti layer 34 is formed on the PtNi alloy layer 12.

In addition, in this embodiment, the Ti layer 34 is formed on the PtNi alloy layer 12, but a modification may be made so that a Mo layer is formed on the Ti layer 34. That is, the Ti layer 34 and the Mo layer may be formed between the PtNi alloy layer 12 and the first laminated structure layer 19.

In addition, in this embodiment, the Ti layer 34 is formed on the PtNi alloy layer 12, but a modification may be made so that a laminated film instead of the Ti layer 34 is formed on the PtNi alloy layer 12, and the laminated film is a film in which at least two films among an Al film, a Ni film, and a Mo film are laminated.

### (Second Embodiment)

A method of manufacturing a Schottky barrier diode according to another aspect of the invention will be described with reference to Fig. 1, Figs. 3A and 3B, Fig. 4, and Fig. 5.

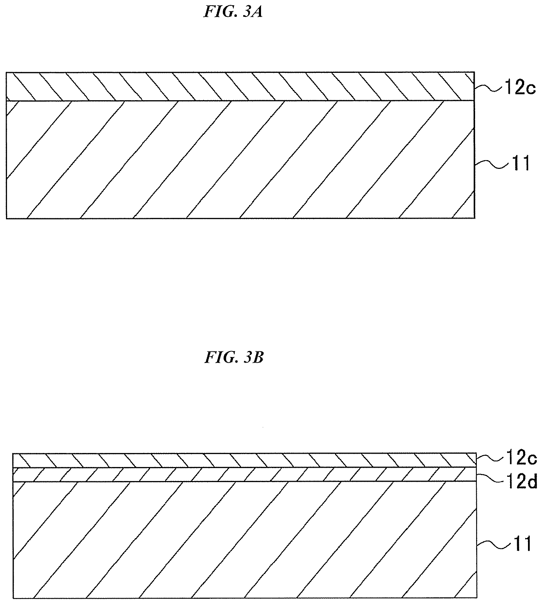

Figs. 3A and 3B, Fig. 4, and Fig. 5 are cross-sectional views describing a method of preparing a Schottky junction portion illustrated in Fig. 1.

As illustrated in Fig. 1, the silicon layer 11 is formed on the silicon substrate 10. The silicon layer 11 is, for example, an epitaxial layer.

Next, an oxide film (not illustrated) is formed on a surface of the silicon layer 11, and the guard ring layer 20 is formed on the silicon layer 11. In addition, the channel stopper layer 31 is formed in the silicon layer 11. Next, the passivation layer 32 is formed on the silicon layer 11.

Next, an oxide film of a Schottky junction surface of the silicon layer 11 is removed through etching (not illustrated).

Next, as illustrated in Fig. 3A, a Pt layer 12c is formed on the silicon layer 11 including the Schottky junction surface (process (a)). Next, a heat treatment is performed on the Pt layer 12c and the silicon layer 11 at a temperature of 150°C to 300°C to form a Pt silicide layer 12d on the silicon layer 11 as illustrated in Fig. 3B (process (b)). At this time, the Pt layer 12c that is not silicided remains on the Pt silicide layer 12d. Note that, in this embodiment, the Pt layer 12c that is not silicided remains on the Pt silicide layer 12d, but the Pt layer 12c that is not silicided may not remain on the Pt silicide layer 12d.

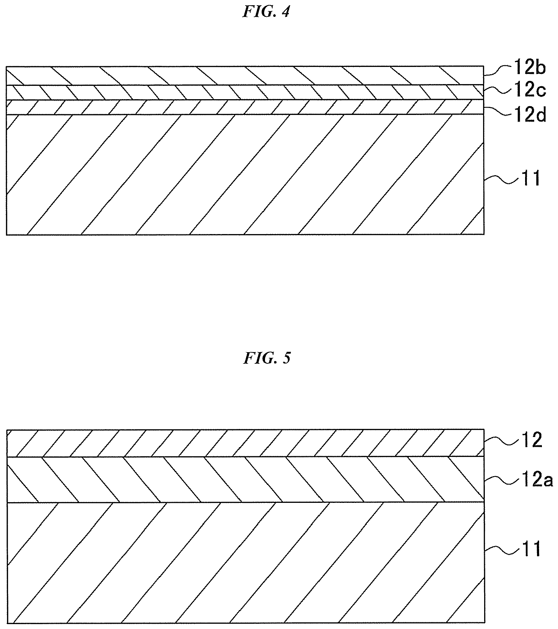

Next, as illustrated in Fig. 4, a Ni layer 12b is formed on the Pt silicide layer 12d and the Pt layer 12c (process (c)).

Next, the Ti layer 34 is formed on the Ni layer 12b. Note that, in this embodiment, the Ti layer 34 is formed, but the process may proceed to the subsequent process without forming the Ti layer 34. In addition, each of the Pt layer 12c, the Ni layer 12b, and the Ti layer 34 may be formed by using any film forming method among a vapor deposition method, a sputtering method, and a CVD method.

Next, a heat treatment is performed on the silicon layer 11, the Pt silicide layer 12d, the Pt layer 12c, and the Ni layer 12b at a temperature of 300°C to 600°C. According to this, the silicide layer 12a containing Pt and Ni is formed on the silicon layer 11, and the PtNi alloy layer 12 or the mixed layer of Pt and Ni is formed on the silicide layer 12a as illustrated in Fig. 5 (process (d)).

A peak value of the concentration of Pt in the silicide layer with a thickness of 50 nm on the silicide layer side from the interface between the silicide layer 12a and the silicon layer 11, or a peak value of the concentration of Pt in the silicide layer 12a in a case where the thickness of the silicide layer 12a is less than 50 nm can be set to 1 at% to 60 at% by adjusting the thicknesses of the Pt layer 12c and the Ni layer 12b and a ratio of the thicknesses.

In other words, the Pt layer 12c is formed on the silicon layer 11 before forming the silicide layer 12a containing Pt and Ni, and a heat treatment is performed on the Pt layer 12c and the silicon layer 11 at a temperature of 150°C to 300°C to form the Pt silicide layer 12d on the silicon layer 11. Accordingly, the peak value of the concentration of Pt in the subsequently formed silicide layer 12a with a thickness of 50 nm on the silicide layer 12a side from the interface between the silicide layer 12a containing Pt and Ni and the silicon layer 11, or the peak value of the concentration of Pt in the silicide layer 12a in a case where the thickness of the silicide layer is less than 50 nm can be set to 1 at% to 60 at%. Particularly, the peak value of the concentration of Pt can be caused to occur at the interface between the silicide layer 12a and the silicon layer 11 or on the interface side in the silicide layer 12a. According to this, the Schottky barrier height (ΦBn) can be controlled to various values, and as a result, desired characteristics in the Schottky barrier diode can be obtained.

Next, as illustrated in Fig. 1, the Al layer 13 is formed on the Ti layer 34, and the Ni layer 14 is formed on the Al layer 13. Next, a photoresist film (not illustrated) is formed on the Ni layer 14, the Al layer 13, and the Ti layer 34, and the Ni layer 14, the Al layer 13, and the Ti layer 34 are etched by using the photoresist film as a mask. According to this, a pattern formed by the Ni layer 14, the Al layer 13, and the Ti layer 34 is formed. Note that, the Al layer 13 and the Ni layer 14 are also referred to as the first laminated structure layer 19.

Next, a polyimide film is formed on an entire surface including the Ni layer 14, and the polyimide film is patterned. According to this, the polyimide film 33 remains on side walls of the Ni layer 14, the Al layer 13, and the Ti layer 34, and on the passivation layer 32 and the Ni layer 14.

Next, a metal layer as the rear electrode 21 is formed on a rear surface of the silicon substrate 10. The metal layer may be formed by a film forming method by a vapor deposition method or a sputtering method.

Note that, in this embodiment, after the PtNi alloy layer 12 or the mixed layer of Pt and Ni is formed on the silicide layer 12a, the PtNi alloy layer 12 or the mixed layer of Pt and Ni remains, but the PtNi alloy layer 12 or the mixed layer of Pt and Ni may be removed after the PtNi alloy layer 12 is formed on the silicide layer 12a.

### (Third Embodiment)

A method of manufacturing a Schottky barrier diode according to still another aspect of the invention will be described with reference to Fig. 1, Fig. 3B, Fig. 4, and Fig. 5.

As illustrated in Fig. 1, as in the second embodiment, the silicon layer 11 is formed on the silicon substrate 10, an oxide film (not illustrated) is formed on a surface of the silicon layer 11, the guard ring layer 20 is formed in the silicon layer 11, and the channel stopper layer 31 is formed in the silicon layer 11. Next, as in the second embodiment, the passivation layer 32 is formed on the silicon layer 11, and an oxide film of a Schottky junction surface of the silicon layer 11 is removed (not illustrated).

Next, as illustrated in Fig. 3B, the Pt layer 12c is formed on the silicon layer 11 while heating the silicon layer 11 including the Schottky junction surface at a temperature of 150°C to 300°C. According to this, the Pt silicide layer 12d is formed on the silicon layer 11 while forming the Pt layer 12c (process (a)). At this time, the Pt layer 12c that is not silicided remains on the Pt silicide layer 12d. Note that, in this embodiment, the Pt layer 12c that is not silicided remains on the Pt silicide layer 12d, but the Pt layer 12c that is not silicided may not remain on the Pt silicide layer 12d.

Next, the Pt layer 12c formed on the passivation film 32 is removed by patterning the Pt layer 12c through etching.

Next, as illustrated in Fig. 4, the Ni layer 12b is formed on the Pt silicide layer 12d and the Pt layer 12c while heating the silicon layer 11 at a temperature of 150°C to 300°C (process (b)). At this time, the Ni layer may be slightly silicided or may not be silicided. Note that, each of the Pt layer 12c and the Ni layer 12b may be formed by using any film forming method among a vapor deposition method, a sputtering method, and a CVD method.

A peak value of the concentration of Pt in the silicide layer with a thickness of 50 nm on the silicide layer side from the interface between the silicide layer 12a and the silicon layer 11, or a peak value of the concentration of Pt in the silicide layer 12a in a case where the thickness of the silicide layer 12a is less than 50 nm can be set to 1 at% to 60 at% by adjusting the thicknesses of the Pt layer 12c and the Ni layer 12b and a ratio of the thicknesses.

Next, a heat treatment is performed on the silicon layer 11, the Pt silicide layer 12d, the Pt layer 12c, and the Ni layer 12b at a temperature of 300°C to 600°C to form a desired silicide structure on the silicon layer 11 (process (d)). With regard to the desired silicide structure, for example, as illustrated in Fig. 5, the silicide layer 12a containing Pt and Ni is formed on the silicon layer 11, and the PtNi alloy layer 12 or the mixed layer of Pt and Ni is formed on the silicide layer 12a.

Next, the Ti layer 34, the Al layer 13, and the Ni layer 14 are sequentially formed on the PtNi alloy layer 12 or the mixed layer of Pt and Ni at a temperature of 100°C to 250°C.

Note that, in this embodiment, the Ti layer 34, the Al layer 13, and the Ni layer 14 are sequentially formed on the PtNi alloy layer 12 or the mixed layer of Pt and Ni, but a Ni layer, a Ti layer, a Mo layer, and an Al layer can also be sequentially formed on the PtNi alloy layer 12 or the mixed layer of Pt and Ni at a temperature of 100°C to 250°C.

In addition, in this embodiment, the Ni layer 12b is formed on the Pt silicide layer 12d and the Pt layer 12c while heating the silicon layer 11 at a temperature of 150°C to 300°C, but the following modification may be made.

As illustrated in Fig. 4, the Ni layer 12b, the Ti layer 34, the Mo layer, and the Al layer are continuously formed on the Pt silicide layer 12d and the Pt layer 12c while heating the silicon layer 11 at a temperature of 100°C to 250°C (process (b)). At this time, in this embodiment, the Mo layer corresponds to a reference numeral 13 shown in Fig. 1, and the Al layer corresponds to a reference numeral 14 shown in Fig. 1. Note that, each of the Pt layer 12c, the Ni layer 12b, the Ti layer 34, the Mo layer, and the Al layer may be formed by using any film forming method among a vapor deposition method, a sputtering method, and a CVD method.

Next, the Ni layer 12b, the Ti layer 34, the Mo layer, and the Al layer are patterned through etching to remove a part of the Ni layer 12b, the Ti layer 34, the Mo layer, and the Al layer formed on the passivation film 32 (refer to Fig. 1).

Next, a heat treatment is performed on the silicon layer 11, the Pt silicide layer 12d, the Pt layer 12c, the Ni layer 12b, the Ti layer 34, the Mo layer, and the Al layer at a temperature of 300°C to 600°C to form a desired silicide structure on the silicon layer 11 (process (d)). With regard to the desired silicide structure, for example, as illustrated in Fig. 5, the silicide layer 12a containing Pt and Ni is formed on the silicon layer 11, and the PtNi alloy layer 12 or the mixed layer of Pt and Ni is formed on the silicide layer 12a.

Note that, with regard to this embodiment and the above-described modification example, a method of forming the polyimide film 33 and the rear electrode 21 illustrated in Fig. 1 is similar to the second embodiment.

In addition, with regard to this embodiment and the above-described modification example, the PtNi alloy layer 12 or the mixed layer of Pt and Ni may be removed as in the second embodiment.

### (Fourth Embodiment)

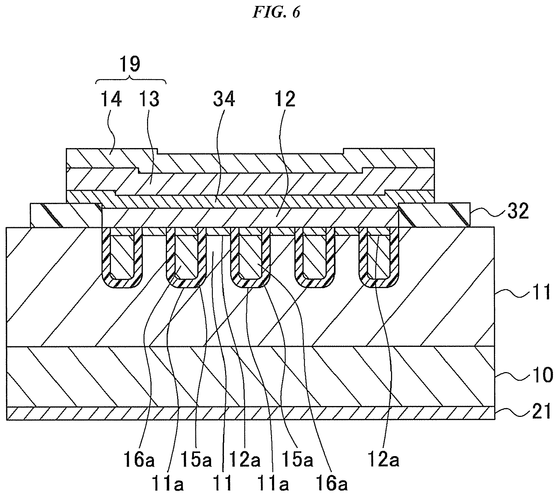

Fig. 6 is a cross-sectional view illustrating a trench Schottky barrier diode according to still another aspect of the invention, and the same reference numerals will be given the same portion as in Fig. 1, and description will be given of only a portion different from the first embodiment.

As illustrated in Fig. 6, a plurality of grooves 11a are formed in the silicon layer 11. In other words, the silicon layer 11 is disposed adjacent to the plurality of grooves 11a. An insulator layer 15a is formed on an inner wall of each of the plurality of grooves 11a. A conductor layer 16a is disposed in the groove 11a and on the insulator layer 15a. As the insulator layer 15a, for example, an SiO₂ layer formed through thermal oxidization can be used, and as the conductor layer 16a, for example, a polysilicon layer can be used. Note that, in this embodiment, description is given to the trench Schottky barrier diode in which the plurality of grooves 11a are formed, but a trench Schottky barrier diode in which one groove 1 1a is formed can also be used.

The silicide layer 12a is formed on an upper portion of the conductor layer 16a inside the plurality of grooves 11a. In addition, the silicide layer 12a is formed on a surface of the silicon layer 11 located between the plurality of grooves 11a.

According to this embodiment, the grooves 11a are formed in the silicon layer 11, the insulator layer 15a is formed on an inner wall of each of the grooves 11a, the conductor layer 16a is formed inside the groove 11a and on the insulator layer 15a, the silicide layer 12a is formed on an upper portion of the conductor layer 16a, and the silicide layer 12a is formed on a surface of the silicon layer 11 adjacent to the groove 11a. Even in the Schottky barrier diode having the trench structure, proportions and a concentration distribution of Pt and Ni contained in the silicide layer 12a are adjusted so that a peak value of the concentration of Pt in the silicide layer 12a with a thickness of 50 nm on the silicide layer 12a side from the interface between the silicide layer 12a and the silicon layer 11, or a peak value of the concentration of Pt in the silicide layer 12a in a case where the thickness of the silicide layer 12a is less than 50 nm becomes 1 at% to 60 at%. According to this, the Schottky barrier height (ΦBn) can be controlled to various values, and as a result, desired characteristics can be obtained.

### Example 1

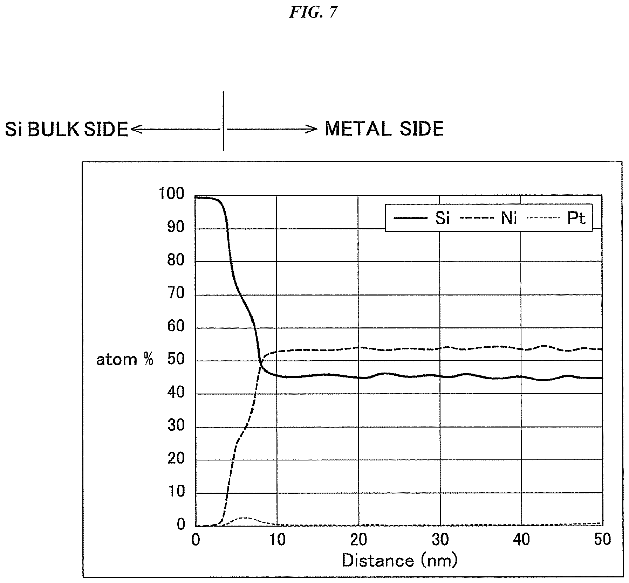

Fig. 7 is a view illustrating a profile of proportions of respective elements Si, Pt, and Ni in a silicide layer 12a with a thickness of 50 nm on the silicide layer 12a side from an interface between the silicon layer 11 and the silicide layer 12a in a prepared sample of the Schottky barrier diode. The profile of the proportions of the respective elements was measured by scanning transmission electron microscope (STEM)/energy dispersive X-ray spectroscopy (EDX).

A process of preparing the sample is as follows. Note that, the sample will be described with reference to Fig. 1.

(1) The silicon layer 11 was formed on the silicon substrate 10 by an epitaxial growth method, and the Pt layer is formed on the silicon layer 11 by a vapor deposition method while heating the silicon substrate at a temperature of 150°C to 300°C. Next, (2) the Pt layer is patterned by a photographic process and an etching process. Next, (3) the Ni layer is formed by a vapor deposition method at a temperature of 150°C to 300°C. (4) Next, any of a Ti layer, a lamination layer of Ti/Al, a lamination layer of Ti/Al or Ni, a lamination layer of Ti/Mo/Al, and a lamination layer of Ti/Mo/Al/Ni is formed on the Ni layer at a temperature of 150°C to 300°C by a vapor deposition method. Next, (5) metals other than the Pt layer are patterned by a photographic process and an etching process. Next, (6) the silicon substrate 10 and the layers on the silicon substrate 10 are heat-treated (annealed) at a temperature of 300°C to 600°C to form the silicide layer 12a containing Pt and Ni. Next, (7) polyimide (PI) is applied, and patterning and baking are performed. Next, (8) processing such as rear surface grinding and etching of the silicon substrate 10 is performed to obtain a desired silicon substrate thickness. Next, (9) a back metal (Ti/Ni/Al) is formed on a rear surface of the silicon substrate 10. According to this, the rear electrode 21 of the silicon substrate 10 is formed.

A concentration profile was measured on the silicide layer 12a side from the interface between the silicon layer 11 and the silicide layer 12a prepared as described above with the STEM/EDX.

According to this embodiment, a peak value of the concentration of Pt in the silicide layer 12a with a thickness of 50 nm on the silicide layer 12a side from the interface between the silicide layer 12a and the silicon layer 11 was 3 at% or less. In addition, the peak value of the concentration of Pt was caused to occur at the interface between the silicide layer 12a and the silicon layer 11 or on the interface side in the silicide layer 12a.

The peak value of the concentration of Pt can be set to 1 at% to 60 at% by adjusting conditions such as the thicknesses and a thickness ratio of the Pt layer 12c and the Ni layer 12b formed on the silicon layer 11 and the annealing temperature. According to this, the Schottky barrier height (ΦBn) can be controlled to various values, and as a result, desired characteristics in the Schottky barrier diode can be obtained.

### Example 2

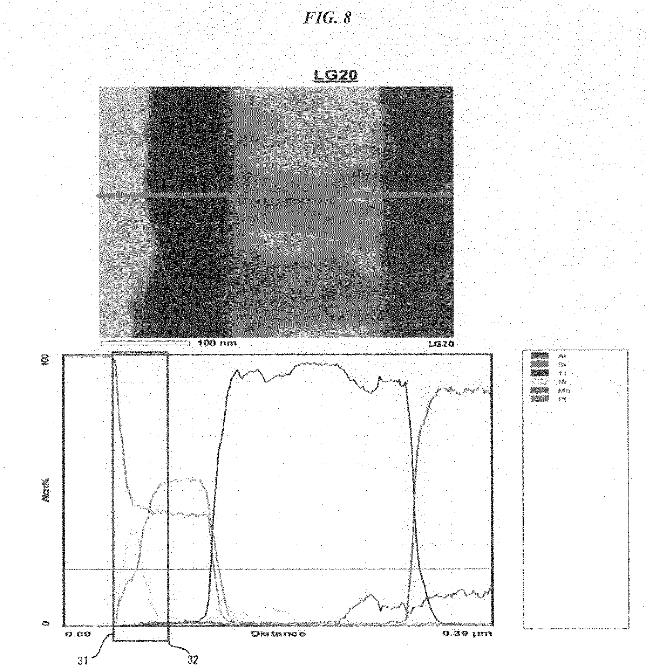

Fig. 8 is a view illustrating a profile of proportions of the respective elements Si, Pt, and Ni in the silicide layer 12a with a thickness of 50 nm (refer to a reference numeral 32 in Fig. 8) on the silicide layer 12a side from the interface (refer to a reference numeral 31 in Fig. 8) between the silicon layer 11 and the silicide layer 12a in a prepared sample of the Schottky barrier diode. The profile of the proportions of the respective elements was measured by STEM/EDX.

A process of preparing the sample is as follows. Note that, the sample will be described with reference to Fig. 1.

(1) The silicon layer 11 was formed on the silicon substrate 10 by an epitaxial growth method, and a Pt layer is formed on the silicon layer 11 while heated at a temperature of 150°C to 300°C. According to this, a Pt silicide is formed between the Pt layer and the silicon layer 11. In other words, the Pt layer is formed on the silicon layer 11 while forming the Pt silicide. (2) Next, the Ni layer is formed at a temperature of 150°C to 300°C. This is continuous vapor deposition (continuous sputtering). Next, (3) a lamination layer of Pt/Ni is patterned by a photographic process and etching. Next, (4) annealing is performed at a temperature of 300°C to 600°C. According to this, the silicide layer 12a is formed on the silicon layer 11. Next, (5) any of a Ti layer, a lamination layer of Ti/Al, a lamination layer of Ti/Al or Ni, a lamination layer of Ti/Mo/Al, and a lamination layer of Ti/Mo/Al/Ni is formed on the lamination layer of Pt/Ni at a temperature of 150°C to 300°C by a vapor deposition method. Next, (6) metals other than the Pt layer are patterned by a photographic process and an etching process. Next, (7) polyimide (PI) is applied, and patterning and baking are performed. Next, (8) processing such as rear surface grinding and etching of the silicon substrate 10 is performed to obtain a desired silicon substrate thickness. Next, (9) a back metal (Ti/Ni/Al) is formed on a rear surface of the silicon substrate 10. According to this, the rear electrode 21 of the silicon substrate 10 is formed.

Note that, in the process of preparing the sample, after patterning the lamination layer of Pt/Ni by the photographic process and the etching in (3), annealing is performed at a temperature of 300°C to 600°C in (4), but the lamination layer of Pt/Ni may be patterned by the photographic process and the etching in (3) after forming the silicide layer 12a on the silicon layer 11 by performing annealing at a temperature of 300°C to 600°C in (4).

A concentration profile was measured on the silicide layer 12a side from the interface between the silicon layer 11 and the silicide layer 12a prepared as described above with the STEM/EDX.

According to this embodiment, a peak value of the concentration of Pt in the silicide layer 12a with a thickness of 50 nm on the silicide layer 12a side from the interface between the silicide layer 12a and the silicon layer 11 was approximately 54 at%.

The peak value of the concentration of Pt can be set to 1 at% to 60 at% by adjusting conditions such as the thicknesses and a thickness ratio of the Pt layer 12c and the Ni layer 12b formed on the silicon layer 11 and the annealing temperature. According to this, the Schottky barrier height (ΦBn) can be controlled to various values, and as a result, desired characteristics in the Schottky barrier diode can be obtained.

### EXPLANATION OF SYMBOLS

- 10: SILICON SUBSTRATE
- 11: SILICON LAYER
- 11a: GROOVE
- 12: PtNi ALLOY LAYER
- 12a: SILICIDE LAYER
- 12b: Ni LAYER
- 12c: Pt LAYER
- 12d: Pt SILICIDE LAYER
- 13: Al LAYER
- 14: Ni LAYER
- 15a: INSULATOR LAYER
- 16a: CONDUCTOR LAYER
- 18: SECOND LAMINATED STRUCTURE LAYER
- 19: FIRST LAMINATED STRUCTURE LAYER
- 20: GUARD RING

## Claims

1. A Schottky barrier diode, comprising:
a silicon layer; and
a silicide layer that is disposed on the silicon layer and contains Pt and Ni,
wherein a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm is 1 at% to 60 at%.

2. The Schottky barrier diode according to claim 1, further comprising:
a PtNi alloy layer or a mixed layer of Pt and Ni disposed on the silicide layer.

3. The Schottky barrier diode according to claim 1 or 2, further comprising:
a guard ring that is located at an end of the silicide layer and is disposed inside the silicon layer.

4. The Schottky barrier diode according to claim 1 or 2, further comprising:
a groove that is formed in the silicon layer and is located below the silicide layer;
an insulator layer disposed on an inner wall of the groove; and
a conductor layer that is disposed inside the groove and on the insulator layer,
wherein the silicon layer is disposed adjacent to the groove.

5. The Schottky barrier diode according to claim 1 or 2,
wherein a first laminated structure layer or a second laminated structure layer is disposed on the silicide layer,
the first laminated structure layer is a layer in which an Al layer and a Ni layer are sequentially laminated, and
the second laminated structure layer is a layer in which the Ni layer and the Al layer are sequentially laminated.

6. The Schottky barrier diode according to claim 1 or 2,
wherein a Ti layer or a Mo layer is disposed on the silicide layer.

7. The Schottky barrier diode according to claim 1 or 2,
wherein a Ti layer is disposed on the silicide layer, and a Mo layer is disposed on the Ti layer.

8. The Schottky barrier diode according to claim 1 or 2, further comprising:
a laminated film disposed on the silicide layer,
wherein the laminated film is a film in which at least two films among an Al film, a Ni film, and a Mo film are laminated.

9. The Schottky barrier diode according to claim 1 or 2,
wherein the silicon layer is an epitaxial layer, and
a silicon substrate is disposed below the epitaxial layer.

10. The Schottky barrier diode according to claim 1 or 2,
wherein the peak value of the concentration of Pt occurs at the interface or on the interface side in the silicide layer.

11. A method of manufacturing a Schottky barrier diode, comprising:
a process (a) of forming a Pt layer on a silicon layer;
a process (b) of performing a heat treatment on the Pt layer and the silicon layer at a temperature of 150°C to 300°C to form a Pt silicide layer on the silicon layer;
a process (c) of forming a Ni layer on the Pt silicide layer; and
a process (d) of performing a heat treatment on the silicon layer, the Pt silicide layer, and the Ni layer at a temperature of 300°C to 600°C to form a silicide layer containing Pt and Ni on the silicon layer, and to form a PtNi alloy layer or a mixed layer of Pt and Ni on the silicide layer,
wherein the thicknesses of the Ni layer and the Pt layer, and a ratio of the thicknesses are adjusted, and
a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm is 1 at% to 60 at%.

12. A method of manufacturing a Schottky barrier diode, comprising:
a process (a) of forming a Pt layer on a silicon layer while heating the silicon layer at a temperature of 150°C to 300°C to form a Pt silicide layer on the silicon layer while forming the Pt layer;
a process (b) of forming a Ni layer on the Pt silicide layer; and
a process (d) of performing a heat treatment on the silicon layer, the Pt silicide layer, and the Ni layer at a temperature of 300°C to 600°C to form a desired silicide structure on the silicon layer,
wherein the silicide structure in the process (d) is a silicide layer containing Pt and Ni, and a PtNi alloy layer or a mixed layer of Pt and Ni is formed on the silicide layer containing Pt and Ni, and
a peak value of a concentration of Pt in the silicide layer with a thickness of 50 nm on the silicide layer side from an interface between the silicide layer and the silicon layer, or a peak value of the concentration of Pt in the silicide layer in a case where the thickness of the silicide layer is less than 50 nm after the process (d) is 1 at% to 60 at%.

13. The method of manufacturing a Schottky barrier diode according to claim 12,
wherein the process (b) is a process of forming a Ni layer on the Pt silicide layer while heating the silicon layer at a temperature of 150°C to 300°C.

14. The method of manufacturing a Schottky barrier diode according to claim 12,
wherein the process (b) is a process of forming a Ni layer on the Pt silicide layer while heating the silicon layer at a temperature of 100°C to 250°C.

15. The method of manufacturing a Schottky barrier diode according to claim 12,
wherein the process (b) is a process of sequentially and continuously forming a Ni layer, a Ti layer, a Mo layer, and an Al layer on the Pt silicide layer while heating the silicon layer at a temperature of 100°C to 250°C.

16. The method of forming a Schottky barrier diode according to any one of claims 11 to 14, further comprising:
a process of removing the PtNi alloy layer or the mixed layer of Pt and Ni after the process (d).
